# DEMANDE DE BREVET EUROPEEN

(11) **EP 4 471 867 A1**
(43) Date de publication de la demande: **04.12.2024**
(21) Numéro de dépôt: 24178286.1
(22) Date de dépôt: 27.05.2024
(51) Int. Cl.: H01L 29/423, H01L 29/66, H01L 29/06, B82Y 10/00

(54) **MÉTHODE DE FABRICATION D'UN DISPOSITIF SEMI-CONDUCTEUR À QUBIT COMPRENANT DES GRILLES LATÉRALES ET DES GRILLES SUPÉRIEURES**

(30) Priorité: 31.05.2023 FR 2305394
(71) Demandeur: Commissariat à l'Energie Atomique et aux Energies Alternatives, 75015 Paris (FR)
(72) Inventeur: SAHIN, Hamza, 38054 GRENOBLE Cedex 09 (FR); BERTRAND, Benoît, 38054 GRENOBLE Cedex 09 (FR); NIEBOJEWSKI, Heimanu, 38054 GRENOBLE Cedex 09 (FR)
(74) Mandataire: Hautier IP

(57) **Abrégé**

L'invention porte sur un procédé de fabrication d'un dispositif semi-conducteur à qubit.

Le dispositif comprend une ailette semi-conductrice des grilles latérales (14, G1, G2) et des grilles supérieures (30). Le procédé comprenant:

• une gravure de tranchées (Fig. 2; 20, 21, 22),
• un dépôt de couche d'électrode (14) sur le flanc des tranchées (Fig. 3),
• un remplissage un matériau diélectrique (15; Figures 3, 4).

Avantageusement, la grille latérale contrôle électrostatiquement une distribution des porteurs de charge dans une structure de type métal-oxyde-semiconducteur (MOS), notamment pour des applications à qubits de spin.

## Description

### DOMAINE TECHNIQUE

La présente invention concerne le domaine de la microélectronique et de l'électronique quantique en particulier. Elle trouve par exemple pour application particulièrement avantageuse la réalisation de grilles latérales dans des dispositifs quantiques à bits quantiques (appelés quantum bits ou qubits), notamment pour des dispositifs basés sur des architectures à qubits de spin.

### ETAT DE LA TECHNIQUE

Les dispositifs semi-conducteurs mis en oeuvre dans des architectures quantiques basées sur le contrôle et la détection d'état de points quantique nécessitent typiquement des qualités d'interfaces très élevées pour éviter que la distribution de charges au niveau des points quantiques ne soit impactée par la présence de pièges de charge au niveau desdites interfaces.

Une approche développée dans ce contexte consiste à utiliser des hétérostructures, qui sont typiquement des empilements de couches de silicium et de silicium-germanium, afin de bénéficier d'une interface sans défauts obtenue par épitaxie. Un inconvénient de cette approche est que le budget thermique acceptable pour ces structures à hétérojonctions est relativement faible. Cela impose des contraintes supplémentaires et/ou des limitations pour la fabrication industrielle de tels dispositifs, notamment en termes de modifications et d'adaptation des procédés technologiques à mettre en oeuvre. L'intégration de tels dispositifs dans des systèmes embarqués complets de type SOC (« System On Chip ») est également plus limitée.

Une autre solution consiste à conserver une structure classique de type métal-oxyde-semiconducteur (MOS), facilement intégrable et présentant des propriétés bien connues et avantageuses. Le document « Temperature-Dependent Characteristics and Electrostatic Threshold Voltage Tuning of Accumulated Body MOSFETs, A. B. M. Hasan Talukder et al., IEEE Transactions on Electron Devices, Vol. 69, 8 (2022) » présente une étude du comportement d'un MOSFET à basse température.. Le MOSFET présenté dans ce document est basé sur la formation d'une unique grille latérale entourant les parois d'une zone active située en saillie du substrat. Cette grille latérale permet de moduler l'environnement électrostatique au niveau de la zone active du dispositif semi-conducteur, sans pour autant permettre un contrôle électrostatique des charges loin des interfaces. De plus, la fabrication d'un tel dispositif n'est pas directement transposable industriellement. Pour des applications quantiques en particulier, une fabrication industrielle maîtrisée, satisfaisant aux exigences de qualité requises, est un enjeu important pour le développement de ces technologies.

Un objectif de l'invention est de répondre à ce besoin, et de pallier au moins en partie les inconvénients des solutions connues.

En particulier, un objet de l'invention est un procédé industrialisable de réalisation d'une grille latérale pour un dispositif semi-conducteur. Un autre objet de l'invention est un dispositif semi-conducteur à grille latérale.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de réalisation d'un dispositif comprenant une structure de type métal-oxyde-semiconducteur (MOS) formée à partir d'un empilement comprenant successivement, selon une direction z, une couche de support, une couche isolante et une couche semi-conductrice. Le dispositif comprend en outre des première et deuxième grilles latérales isolée électriquement entre elles, et configurées pour contrôler électrostatiquement une distribution de porteurs de charge dans la couche semi-conductrice perpendiculairement à la direction z.

Le procédé comprend :
- une formation d'au moins une tranchée traversant la couche semi-conductrice et s'étendant jusque dans la couche isolante, ladite formation de tranchée définissant ainsi une zone active de la couche semi-conductrice, et exposant des bords de ladite zone active,
- une formation d'une première barrière diélectrique sur chaque bord exposé de la zone active, ladite première barrière diélectrique formant en partie un flanc de ladite au moins une tranchée,
- un dépôt d'une couche d'électrode sur le flanc de l'au moins une tranchée, et de préférence sur un fond de l'au moins une tranchée, ladite couche d'électrode présentant au moins une portion dite latérale sur le flanc de l'au moins une tranchée, ladite au moins une portion latérale formant les première et deuxième grilles latérales, et de préférence une portion dite basale sur le fond de l'au moins une tranchée,
- un remplissage de l'au moins une tranchée par un matériau diélectrique,
- une formation d'une deuxième barrière diélectrique sur une face supérieure de la zone active et sur une extrémité supérieure de la grille latérale bordant la zone active,
- une formation d'une grille verticale sur la deuxième barrière diélectrique, au-dessus de la zone active, configurée pour contrôler électrostatiquement la distribution de porteurs de charge dans la couche semi-conductrice selon la direction z, de façon à obtenir la structure de type métal-oxyde-semiconducteur.

Les étapes de ce procédé sont parfaitement maîtrisables industriellement. Le procédé garantit ainsi une qualité de fabrication compatible avec les spécifications requises pour des dispositifs MOS comprenant une grille latérale, en particulier pour des dispositifs MOS quantiques comprenant une grille latérale.

Il est en outre possible d'intégrer la fabrication du dispositif MOS à grille latérale dans un flux de procédé plus vaste, comprenant typiquement la formation de différents niveaux métalliques et d'interconnexions. Le procédé selon l'invention offre ainsi une solution améliorée pour la réalisation de dispositifs MOS à grille latérale.

Un autre aspect de l'invention concerne un tel dispositif MOS à grille latérale, comprenant typiquement une grille latérale formée par le procédé selon l'invention. En particulier, un tel dispositif comprend une structure de type métal-oxyde-semiconducteur formée à partir d'un empilement comprenant successivement, selon une direction z, une couche de support, une couche isolante et une couche semi-conductrice dans laquelle est définie une zone active ; le dispositif comprend en outre une première grille latérale sur un premier bord de la zone active, configurée pour contrôler électrostatiquement une distribution de porteurs de charge dans la couche semi-conductrice perpendiculairement à la direction z, et une grille verticale au-dessus de la zone active, configurée pour contrôler électrostatiquement la distribution de porteurs de charge dans la couche semi-conductrice selon la direction z.

Avantageusement, le dispositif comprend une deuxième grille latérale sur un deuxième bord de la zone active, configurée pour contrôler électrostatiquement une distribution de porteurs de charge dans la couche semi-conductrice perpendiculairement à la direction z, ladite deuxième grille latérale étant isolée électriquement vis-à-vis de la première grille latérale. La grille verticale est isolée électriquement vis-à-vis des première et deuxième grilles latérales. Le dispositif comprend en outre un matériau diélectrique encapsulant lesdites première et deuxième grilles latérales.

Ainsi, le contrôle électrostatique de la distribution de porteurs de charge dans la couche semi-conductrice est amélioré. En particulier, cela permet d'éviter les interactions entre la distribution de charges et les interfaces potentiellement gênantes. Il est ainsi possible de confiner les charges au sein de la zone active du dispositif, loin des interfaces.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1 à 6 illustrent schématiquement en coupe transverse des étapes de fabrication d'une grille latérale d'un dispositif semi-conducteur, selon un mode de réalisation de la présente invention.
Les figures 7A et 8A illustrent schématiquement en coupe transverse des étapes de fabrication de deux grilles latérales d'un dispositif semi-conducteur, selon un autre mode de réalisation de la présente invention. Les figures 7B et 8B illustrent schématiquement en perspective les étapes de fabrication illustrées aux figures 7A et 8A correspondantes. Les figures 9, 10, 11 illustrent schématiquement en perspective des étapes de fabrication de grilles verticales et de régions source et drain, selon un premier mode de réalisation de la présente invention.
Les figures 12, 13 illustrent schématiquement en perspective des étapes de fabrication de grilles verticales et de régions source et drain, selon un deuxième mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs et/ou les dimensions des différentes couches, motifs et reliefs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, le dispositif est un dispositif quantique et la distribution de porteurs de charge est localisée au niveau d'un point quantique ou d'une boite quantique. Les boites quantiques sont typiquement formées par le biais d'un confinement électrostatique (via l'application d'une tension sur les grilles) et d'un confinement structurel (dans la couche mince de topSi typiquement).

Selon un exemple, les première et deuxième grilles latérales et la grille verticale sont métalliques ou conductrices à des températures cryogéniques inférieures ou égales à 50 mK. Les grilles latérales et verticales sont ainsi fonctionnelles même à basse température, typiquement pour des températures de fonctionnement d'un dispositif quantique. Contrairement à des grilles en un matériau de type semi-conducteur dopé ou fortement dopé, des grilles en un matériau métallique ne sont pas sensibles au gel des porteurs qui survient à basse température. Les grilles latérales et verticales métalliques restent ainsi fonctionnelles à basse température.

Selon un exemple, la couche semi-conductrice présente, en projection selon la direction z, une forme comprenant un premier et un deuxième contours fermés qui partagent une section commune. Selon un exemple, la zone active est située dans ladite section commune, les première et deuxième grilles latérales se trouvant respectivement à l'intérieur des premier et deuxième contours fermés.

Selon un exemple, le dispositif comprend en outre des grilles secondaires au-dessus de la couche semi-conductrice de part et d'autre de la section commune, lesdites grilles secondaires étant configurées pour isoler électriquement des régions de source et drain situées aux extrémités de la section commune.

Selon un exemple, le dispositif comprend plusieurs grilles verticales, certaines grilles verticales recouvrant au moins partiellement la zone active, et certaines autres grilles verticales ne couvrant pas la zone active.

Selon un exemple, le dispositif comprend au moins un réservoir de charge de part et d'autre de la zone active, à fleur de la grille verticale.

Selon un exemple, le procédé comprend en outre, avant formation de la deuxième barrière diélectrique, une gravure partielle de la portion latérale de couche d'électrode, configurée pour abaisser l'extrémité supérieure de la grille latérale sous un plan passant par la face supérieure de la zone active. L'extrémité supérieure de la grille latérale est ainsi en retrait de la grille verticale. Cela minimise l'interaction, par exemple capacitive, entre les deux grilles.

Selon un exemple, le procédé comprend, après remplissage de l'au moins une tranchée et avant formation de la deuxième barrière diélectrique, une planarisation configurée pour que l'extrémité supérieure de la grille latérale soit plane parallèlement à un plan passant par la face supérieure de la zone active. Cela facilite l'intégration du dispositif.

Selon un exemple, le dépôt de la couche d'électrode est effectué également sur un fond de l'au moins une tranchée, ladite couche d'électrode présentant ainsi une portion basale sur le fond de l'au moins une tranchée en contact avec la portion latérale sur le flanc de l'au moins une tranchée, ledit procédé comprenant en outre une formation d'un via de contact au travers du matériau diélectrique configurée pour contacter électriquement la portion basale de la couche d'électrode. Cela facilite l'intégration du dispositif, en particulier dans un flux de procédé comprenant des étapes dites de « back end » visant à former différents niveaux métalliques et d'interconnexions.

Selon un exemple, la formation d'au moins une tranchée est configurée pour former une première tranchée d'un premier côté de la zone active et une deuxième tranchée d'un deuxième côté de la zone active, séparée de la première tranchée, et le dépôt de la couche d'électrode forme, respectivement dans les première et deuxième tranchées, des première et deuxième grilles latérales non reliées électriquement entre elles. Cela permet de contrôler plus finement une position de la distribution de porteurs de charge dans la couche semi-conductrice perpendiculairement à la direction z, en appliquant typiquement des tensions de polarisation différentes aux première et deuxième grilles latérales. Il est également possible, dans une configuration où la grille verticale est divisée en deux parties en regard l'une de l'autre, de gérer un échange de porteurs de charge sous les deux parties.

Selon un exemple, la couche semi-conductrice présente une forme comprenant un premier et un deuxième contours fermés qui partagent une section commune, et la zone active est située dans la section commune, les première et deuxième grilles latérales se trouvant respectivement à l'intérieur des premier et deuxième contours fermés. La couche semi-conductrice présente typiquement une forme de huit permettant d'isoler les première et deuxième grilles latérales dans les contours fermés.

Selon un exemple, le procédé comprend en outre une étape de gravure configurée pour couper la couche semi-conductrice de part et d'autre de la section commune, de façon à isoler électriquement des régions de source et drain situées aux extrémités de la section commune.

Selon un exemple, le procédé comprend en outre, lors de la formation de la grille verticale au-dessus de la zone active, une formation de grilles secondaires au-dessus de la couche semi-conductrice de part et d'autre de la section commune, lesdites grilles secondaires étant configurées pour isoler électriquement des régions de source et drain situées aux extrémités de la section commune.

Selon un exemple, l'au moins une grille latérale comprend des première et deuxième grilles latérales non reliées électriquement entre elles.

Selon un exemple, la grille verticale comprend des première et deuxième parties non reliées électriquement entre elles et couvrant partiellement la zone active. Ces première et deuxième parties peuvent être utilisées pour le contrôle et la détection de qubits. Selon un exemple, le dispositif est un dispositif quantique et la distribution de porteurs de charge est localisée au niveau d'un point quantique.

Selon un exemple, le dispositif comprend une structure de type métal-oxyde-semiconducteur et comprend au moins une grille latérale réalisée par un procédé de réalisation selon l'invention.

Selon un exemple, la formation de la couche d'électrode se fait par dépôt conforme sur les flancs et le fond de l'au moins une tranchée. Typiquement, le flanc de la première tranchée longe le premier bord de la zone active. Le flanc de la deuxième tranchée longe le deuxième bord de la zone active. Le fond des tranchées est situé au sein de la couche isolante, sous un plan passant par la face inférieure de la zone active. Les première et deuxième grilles latérales se situent donc contre des flancs latéraux opposés, c'est-à-dire en vis-à-vis, de la zone active. La zone active est ainsi flanquée, de part et d'autre, par les première et deuxième grilles latérales. Ces première et deuxième grilles latérales s'étendent de préférence jusqu'au sein de la couche isolante, sous la zone active. Les première et deuxième grilles latérales comprennent respectivement au moins des première et deuxième portions latérales, et de préférence respectivement des première et deuxième portions basales. Les première et deuxième grilles latérales présentent ainsi chacune un profil en forme de L, en coupe selon le plan zy. Les portions basales facilitent la prise de contact électrique des première et deuxième grilles latérales. L'extension des portions latérales dans la couche isolante permet de mieux gérer le champ électrostatique des première et deuxième grilles latérales. Cela permet en particulier d'éviter des effets parasitant le champ électrostatique. Dans tous les cas, les première et deuxième grilles latérales sont électriquement indépendantes l'une de l'autre.

Selon un exemple, la couche d'électrode est choisie à base d'un métal, par exemple du titane.

Selon un exemple, le matériau diélectrique de remplissage est choisi à base de SiO2.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques et les avantages d'un aspect de l'invention, par exemple le dispositif ou le procédé, peuvent être adaptés mutatis mutandis à l'autre aspect de l'invention.

L'invention porte d'une manière générale sur un procédé de fabrication d'une grille latérale pour un dispositif semi-conducteur, et sur un tel dispositif équipé d'une grille latérale. Un dispositif semi-conducteur selon l'invention comprend typiquement une couche semi-conductrice dans laquelle transitent des porteurs de charge ou des états quantiques. Par exemple et de façon non limitative, cette couche semi-conductrice peut ainsi former un canal de transistor, ou s'intégrer dans une architecture à qubits de spin pour des dispositifs quantiques à bits quantiques (appelés quantum bits ou qubits).

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage.

On entend par « forme présentant un contour fermé » toute forme géométrique comprenant un bord ininterrompu, tel qu'un cercle, un carré, un triangle, une étoile etc... De préférence la forme comprend deux contours fermés ayant un côté commun, tel que deux rectangles ayant un côté en commun.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée SA:B. Une sélectivité SA:B de 10:1 signifie que la vitesse de gravure du matériau A est 10 fois supérieure à la vitesse de gravure du matériau B.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche superficielle de silicium (topSi) présente typiquement une épaisseur selon z. Un motif de grille formé sur une telle couche superficielle présente une hauteur selon z. Les termes relatifs « sur », « surmonte », « sous », « sous-jacent » se réfèrent à des positions prises selon la direction z. Une dimension « latérale » correspond à une dimension selon une direction du plan xy. On entend par une extension « latérale » ou « latéralement », une extension selon une ou des directions du plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

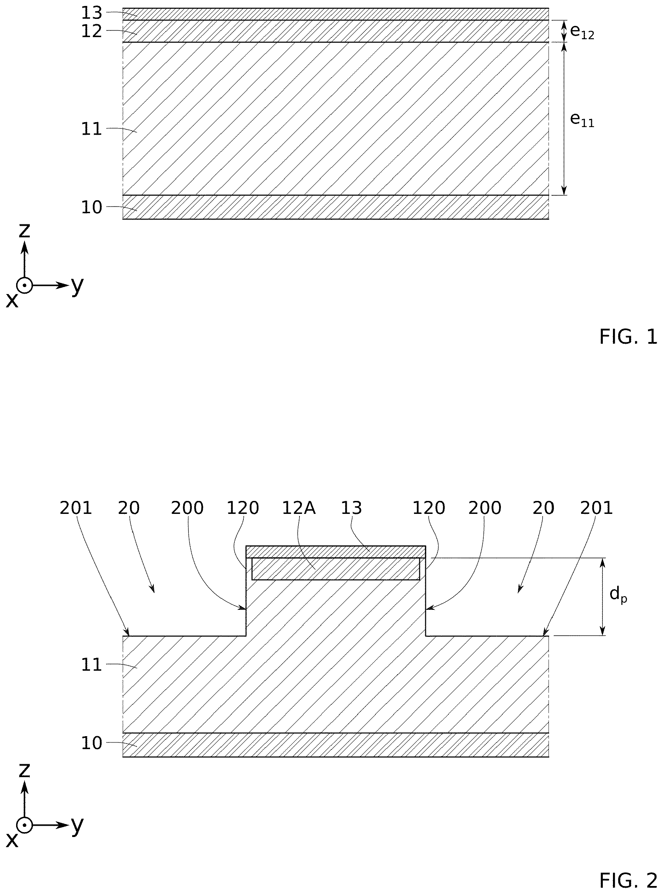

Les figures 1 à 6 illustrent schématiquement en coupe transverse des étapes de fabrication d'une grille latérale d'un dispositif semi-conducteur, selon un mode de réalisation.

Comme illustré à la figure 1, un dépôt de masque dur 13, par exemple à base d'alumine est d'abord effectué sur un substrat de type SOI comprenant en empilement selon z une couche de support 10, typiquement un substrat massif de silicium dit « bulk », une couche isolante 11, typiquement une couche d'oxyde enterrée dite « BOX », et une couche semi-conductrice 12, par exemple une couche de silicium dite topSi. La couche isolante 11 présente typiquement une épaisseur e11 de l'ordre de 200 nm à 300 nm. La couche topSi 12 présente typiquement une épaisseur e12 de l'ordre de 5 nm à 20 nm.

Comme illustré à la figure 2, après définition par lithographie d'un motif comprenant la zone active 12A du dispositif, une gravure sèche anisotrope selon z est effectuée. La profondeur de gravure dp est choisie de façon à former des tranchées 20 s'étendant jusque dans la couche isolante 11, à travers la couche 12 de l'empilement. La profondeur de gravure dp est par exemple de l'ordre de 100 nm. Une gravure ionique réactive (RIE) ou une gravure plasma à base d'espèces fluorocarbonées peut être utilisée pour graver successivement les couches 12 et 11 de l'empilement. Une ou des tranchées 20 présentant des flancs 200 et un ou des fonds 201 sont ainsi formées. Les tranchées 20 exposent les bords 120 de la couche semi-conductrice 12. Une oxydation thermique est effectuée de manière à former une première barrière diélectrique sur chaque bord 120 exposé de la zone active 12A.

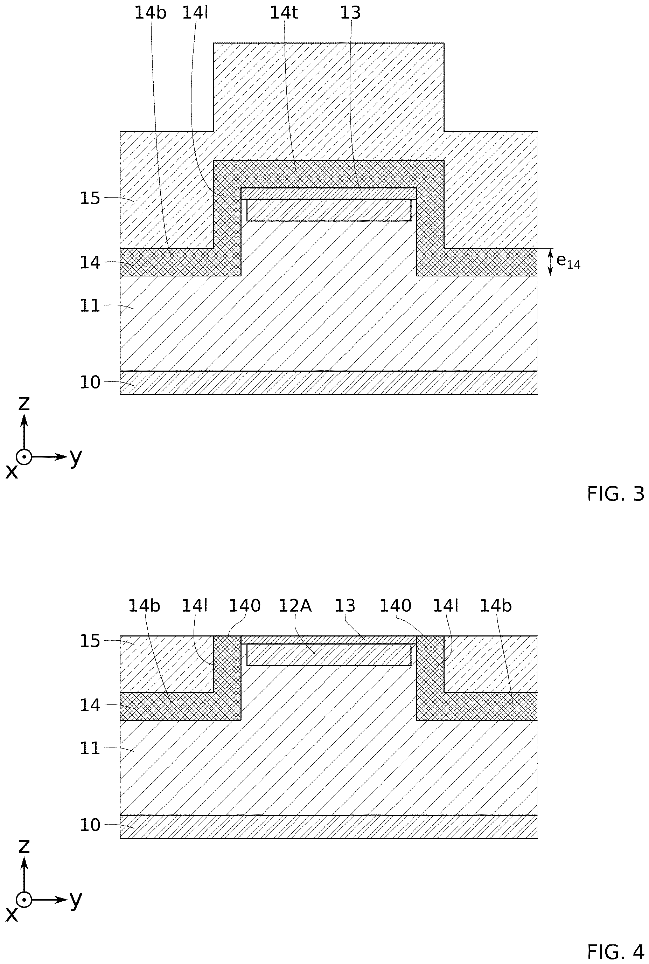

Comme illustré à la figure 3, un dépôt conforme d'une couche d'électrode 14 est d'abord effectué, par exemple par dépôt chimique en phase vapeur CVD. La couche 14 présente typiquement une épaisseur e14 de l'ordre de 10 nm à 20 nm. La couche 14 présente à ce stade des portions basales 14b sur le fond des tranchées 20, des portions latérales 14l sur le flanc des tranchées 20, et une portion sommitale 14t sur le masque dur 13. La couche d'électrode 14 est de préférence à base d'un matériau métallique, par exemple Ti. Après dépôt conforme de la couche d'électrode 14, un remplissage des tranchées 20 par un matériau diélectrique 15 est ensuite effectué. Le matériau diélectrique 15 est typiquement à base de SiO2. Le remplissage peut être effectué de façon usuelle par dépôt conforme de type plasma à haute densité HDP (High Density Plasma) ou de type dépôt chimique en phase vapeur CVD.

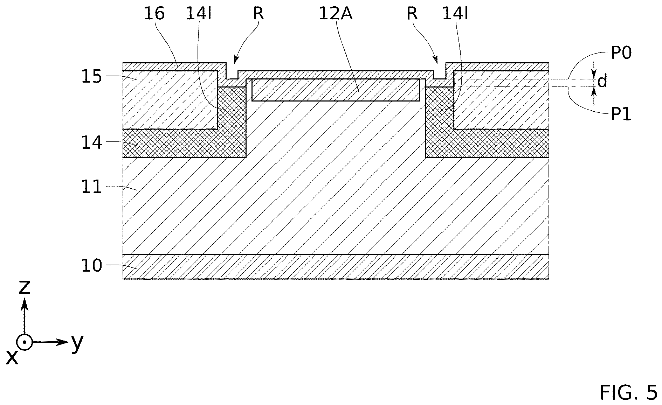

Comme illustré à la figure 4, après remplissage, une étape de planarisation, typiquement par polissage mécano-chimique CMP, est effectuée. Cette étape de planarisation vise à retirer le matériau diélectrique 15 en excès et la portion sommitale 14t. Le polissage CMP est typiquement configuré pour s'arrêter dans la couche 13 de masque dur. Les extrémités 140 des portions latérales 14l sont ainsi formées. Les portions latérales 14l de la couche d'électrode forment une grille latérale autour de la zone active 12A du dispositif. Comme illustré à la figure 5, selon une possibilité préférée, après planarisation, une gravure sélective du matériau de la couche d'électrode vis-à-vis de la couche 13 et du matériau diélectrique 15 est effectuée, par exemple en chimie humide de type « hot SPM » (Sulfuric Peroxide Mixture). Une gravure sèche par plasma à base de chlore (BCL3+CL2) ou de fluor (SF6+CHF3) est également possible, avec de bons résultats de sélectivité entre le matériau de la couche d'électrode et le matériau diélectrique et celui de la couche 13. Cela permet d'abaisser les extrémités 140 des portions latérales 14l sous la face de planarisation. Un retrait R, typiquement dénommé « recess », est ainsi formé. En particulier, la gravure est configurée pour abaisser les extrémités 140 sous un plan P0 correspondant à la face supérieure de la zone active 12A. Cela permet d'éloigner les extrémités 140 des éléments formés ultérieurement sur la face supérieure de la zone active 12A, en particulier de la grille verticale formée ultérieurement sur la face supérieure de la zone active 12A. Les capacités parasites entre la grille latérale et la grille verticale sont ainsi diminuées ou supprimées. Selon un exemple, après recess R les extrémités 140 se trouvent sensiblement dans un plan P1 parallèle au plan P0 et distant du plan P0 d'une distance d comprise entre 2 nm et 10 nm, par exemple de l'ordre de 5 nm. Après formation du recess R, une deuxième barrière diélectrique 16, par exemple à base d'alumine, est formée sur les extrémités 140 et à la surface de la zone active 12A.

Selon une autre possibilité non illustrée, la deuxième barrière diélectrique 16 est formée directement sur la structure illustrée à la figure 4, sans formation préalable de recess R. La deuxième barrière diélectrique 16 est dans ce cas plus épaisse au-dessus de la zone active 12A.

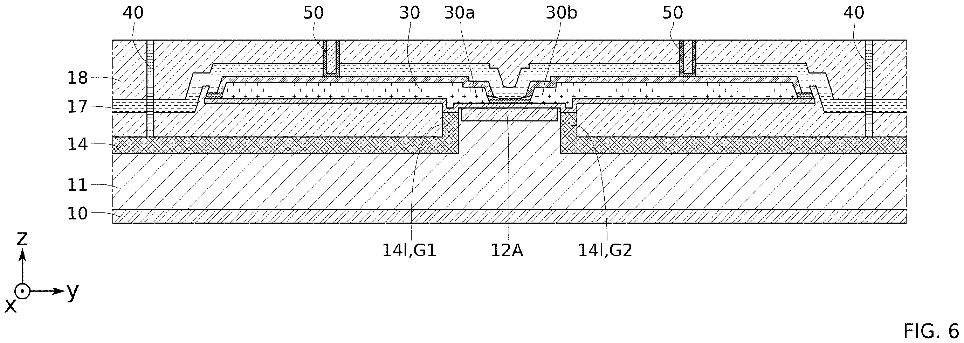

Comme illustré à la figure 6, une ou plusieurs grilles verticales sont ensuite formées, comprenant par exemple, la deuxième barrière diélectrique 16 et/ou une couche dite « high k » à haute constante diélectrique, une couche 30 conductrice, par exemple en silicium polycristallin (polySi) ou en métal (TiN). Le motif de grille verticale couvre au moins en partie la zone active 12A. Il peut comprendre une première partie 30a et une deuxième partie 30b non reliées électriquement entre elles, comme illustré à la figure 6. Ce type d'architecture est typiquement mis en oeuvre pour le contrôle et la détection de qubits dans des dispositifs quantiques. La ou les grilles verticales peuvent être des grilles « factices » ou sacrificielles.

De façon classique, après formation du ou des motifs de grille verticale, un dépôt conforme d'une couche 17 d'arrêt de gravure de contact CESL (Contact Etch Stop Layer), par exemple en SiN, peut être effectué. Ce dépôt peut se faire selon un procédé de dépôt chimique en phase vapeur assisté par plasma PECVD. Un dépôt de matériau 18 diélectrique, par exemple à base de SiO2, est ensuite effectué. Ce dépôt peut se faire selon un procédé connu de dépôt HDP ou à partir de précurseurs de type TEOS (orthosilicate de tétraéthyle). La couche 18 est ensuite planarisée par CMP. Des ouvertures de vias sont ensuite pratiquées au travers des couches 18, 17, 15 par gravures sèches successives, à l'aplomb des grilles verticales et des portions 14l de la couche d'électrode. Des vias de contact 50 sont ainsi formés de façon connue pour contacter électriquement les grilles verticales 30a, 30b. Des vias de contact 40 sont ainsi formés de façon connue pour contacter électriquement les grilles latérales 14l. Les grilles latérales 14l peuvent ainsi être polarisées indépendamment des grilles verticales 30a, 30b. Cela permet de positionner plus précisément la distribution de porteurs de charge au sein de la zone active 12A.

Selon un mode de réalisation illustré plus en détail dans la suite, deux grilles latérales G1, G2 indépendantes l'une de l'autre sont formées de part et d'autre de la zone active 12A. Cela permet de polariser indépendamment ces deux grilles latérales G1, G2. Cela augmente les possibilités de contrôle et de positionnement de la distribution de porteurs de charge au sein de la zone active 12A. Selon une possibilité, les grilles latérales G1, G2 permettent avantageusement d'assister un échange de qubit entre les deux parties 30a, 30b de grilles verticales.

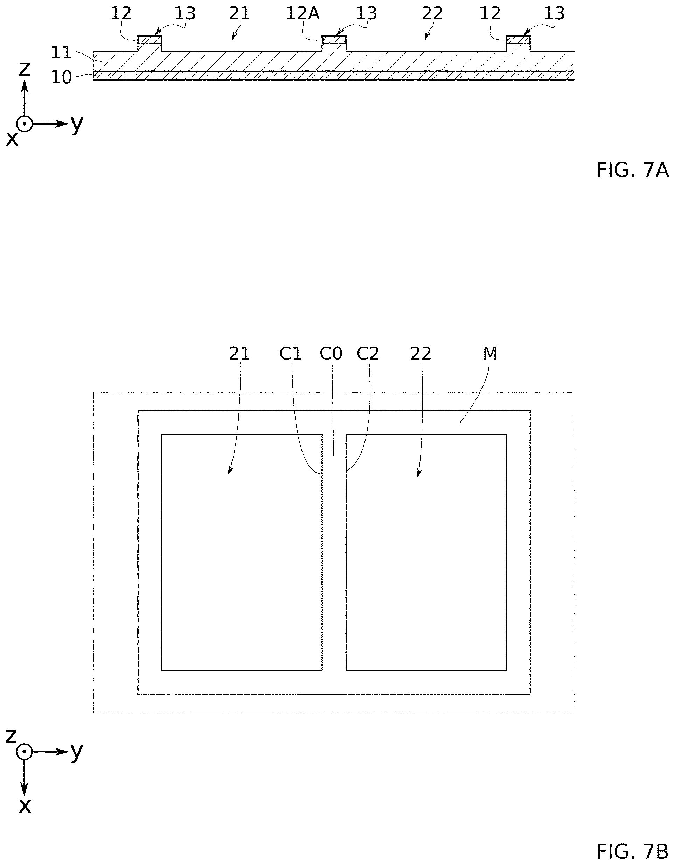

Les figures 7A, 7B illustrent un motif M en forme de huit permettant de réaliser deux grilles latérales G1, G2 indépendantes l'une de l'autre. Ce motif M est formé par lithographie et gravure de la couche semi-conductrice 12 après dépôt du masque dur 13, lors de la formation des tranchées 21, 22. Le motif M comprend typiquement deux contours C1, C2 fermés délimitant deux tranchées 21, 22 sans communication entre elles. La zone active 12A se situe typiquement au niveau de la barre centrale C0 du huit illustré sur les figures.

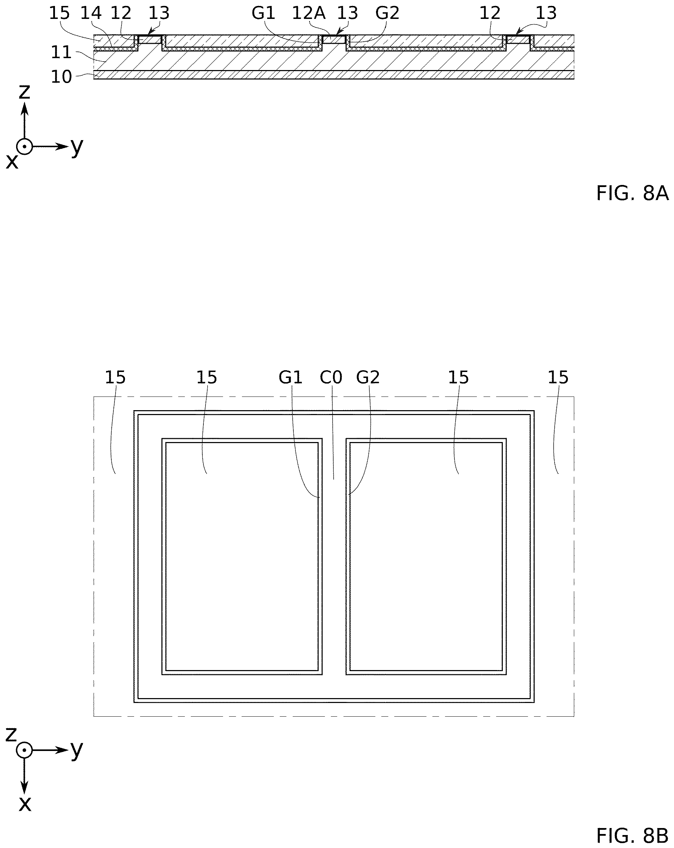

Comme illustré aux figures 8A, 8B, la couche d'électrode 14 est déposée dans les tranchées 21, 22 et un remplissage de matériau diélectrique 15 est effectué, comme précédemment. Après planarisation, deux grilles latérales G1, G2 indépendantes sont formées de part et d'autre de la zone active 12A.

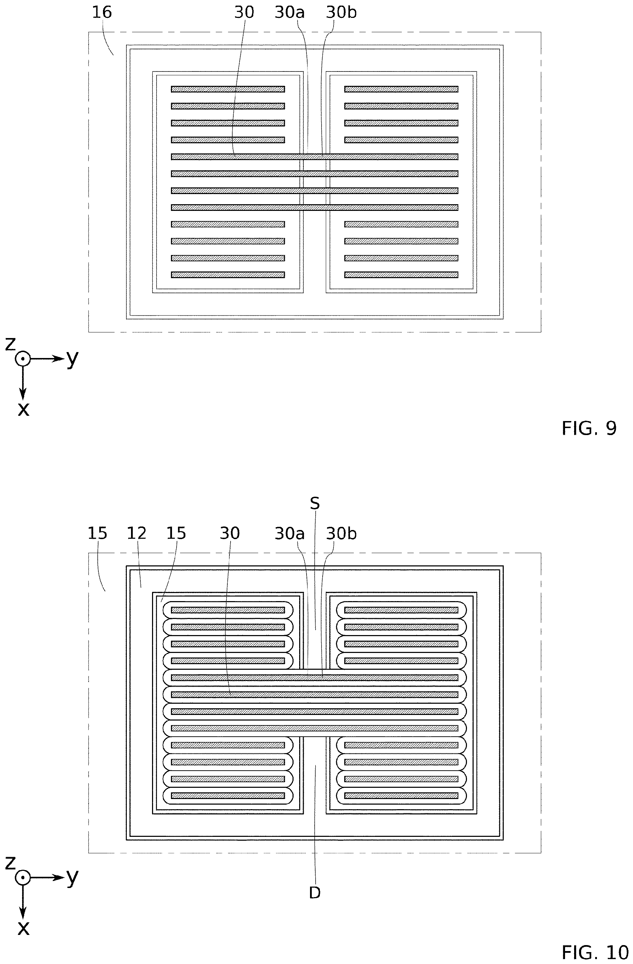

Comme illustré aux figures 9 et 10, Après dépôt de la deuxième barrière diélectrique 16, des grilles verticales 30 sont formées au-dessus de la zone active 12A. Sur les figures, quatre grilles verticales 30a et quatre grilles verticales 30b, à cheval sur la zone active 12A, sont illustrées. Après retrait des parties exposées de la deuxième barrière diélectrique 16, la couche 12 structurée sous forme de huit est exposée. Des régions source S et drain D, ou des réservoirs pour des dispositifs quantiques, sont formés sur ou dans la couche 12 par exemple par épitaxie de part et d'autre de la zone active selon x. Ces régions source et drain S, D, peuvent être dopées in situ lors de l'épitaxie. Elles peuvent être à base de silicium dopé phosphore Si:P ou de silicium-germanium dopé bore SiGe:B par exemple.

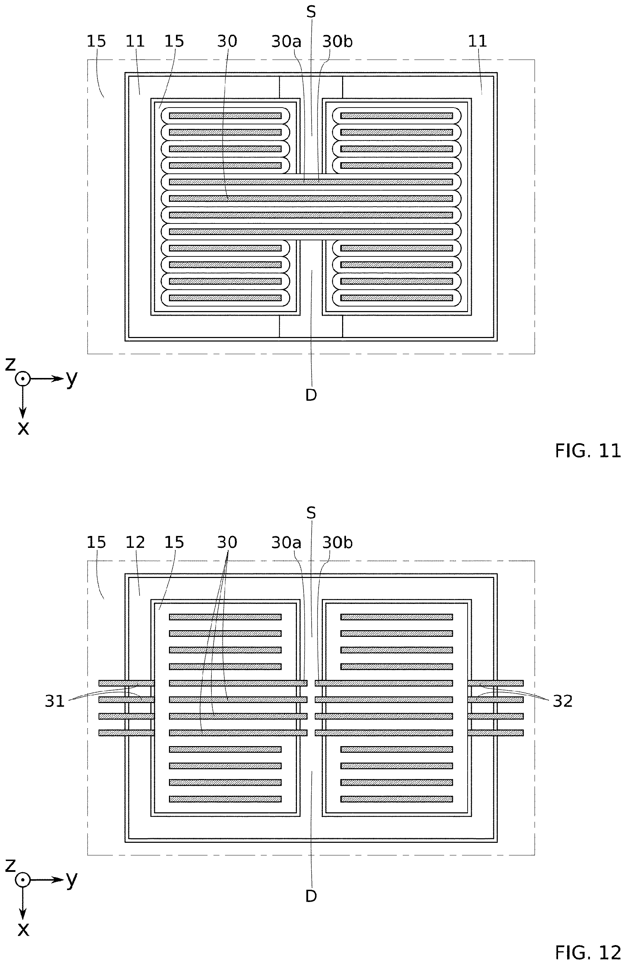

La figure 11 illustre un premier mode de réalisation d'une isolation électrique entre les régions source et drain S, D. Selon ce mode de réalisation, des parties de la couche 12 situées entre les régions source et drain S, D, à l'opposé de la barre centrale C0 du huit, sont retirées par gravure, exposant ainsi le BOX 11 sous-jacent.

La figure 12 illustre un deuxième mode de réalisation d'une isolation électrique entre les régions source et drain S, D. Selon ce mode de réalisation, des grilles secondaires 31, 32 sont formées en même temps que les grilles verticales 30, au-dessus des parties de la couche 12 situées entre les régions source et drain S, D, à l'opposé de la barre centrale du huit. Une polarisation de ces grilles secondaires 31, 32 permet ainsi de bloquer le passage du courant électrique entre les régions source et drain S, D. La définition et la formation des grilles secondaires 31, 32 se fait avantageusement lors de la définition et de la formation des grilles verticales 30, sans étape supplémentaire dans le procédé.

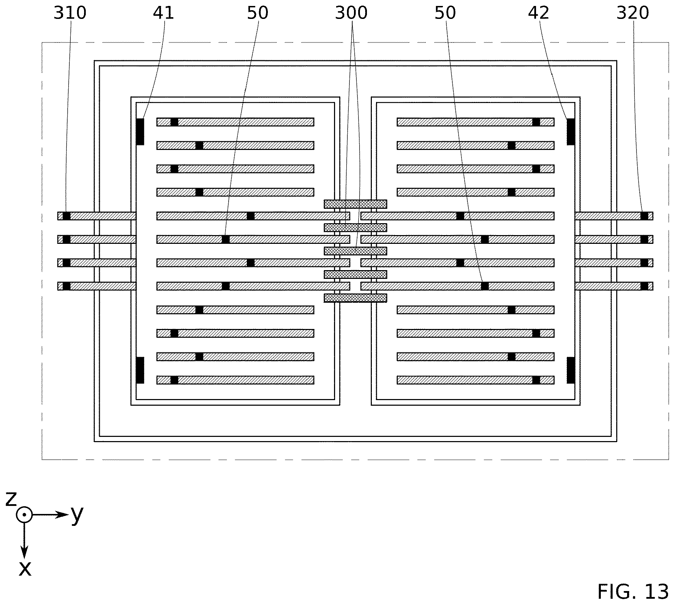

Comme illustré à la figure 13, après encapsulation des grilles verticales, l'ensemble des contacts du dispositif peut être réalisé. Des vias de contact 50 sont ainsi réalisés sur les grilles verticales 30. Des vias de contact 41 et 42 sont ainsi réalisés pour les grilles latérales G1, G2 respectivement. Des vias de contact 310 et 320 sont ainsi réalisés pour les grilles secondaires 31, 32 respectivement. Des grilles d'échange 300 sont également réalisées entre les grilles verticales, pour permettre une modulation électrostatique de la hauteur de barrière tunnel séparant des boites quantiques adjacentes selon x.

Au vu de la description qui précède, il apparaît clairement que le procédé proposé offre une solution particulièrement efficace et versatile pour former une grille latérale pour un dispositif MOS. L'invention n'est pas limitée aux modes de réalisations précédemment décrits.

## Revendications

1. Dispositif semi-conducteur comprenant successivement, en empilement selon une direction z,
- une couche de support (10),
- une couche isolante (11) et
- une couche semi-conductrice (12) dans laquelle est définie une zone active (12A),
le dispositif comprenant en outre une première grille latérale (G1) sur un premier bord (120) de la zone active (12A), configurée pour contrôler électrostatiquement une distribution de porteurs de charge dans la couche semi-conductrice (12) perpendiculairement à la direction z, et
une grille verticale (30, 30a, 30b) au-dessus de la zone active (12A), configurée pour contrôler électrostatiquement la distribution de porteurs de charge dans la couche semi-conductrice (12) selon la direction z, le dispositif étant **caractérisé en ce qu'**il comprend une deuxième grille latérale (G2) sur un deuxième bord (120) de la zone active (12A), configurée pour contrôler électrostatiquement une distribution de porteurs de charge dans la couche semi-conductrice (12) perpendiculairement à la direction z, ladite deuxième grille latérale (G2) étant isolée électriquement vis-à-vis de la première grille latérale (G1),
la grille verticale (30, 30a, 30b) étant isolée électriquement vis-à-vis des première et deuxième grilles latérales (G1, G2), le dispositif comprenant en outre un matériau diélectrique (15) encapsulant lesdites première et deuxième grilles latérales (G1, G2).

2. Dispositif selon la revendication précédente dans lequel la distribution de porteurs de charge est localisée au niveau d'un point quantique, le dispositif étant un dispositif quantique.

3. Dispositif selon la revendication précédente dans lequel les première et deuxième grilles latérales (G1, G2) et la grille verticale (30, 30a, 30b) sont métalliques ou conductrices à des températures cryogéniques inférieures ou égales à 50 mK.

4. Dispositif selon l'une quelconque des revendications précédentes dans lequel la grille verticale comprend des première et deuxième parties (30a, 30b) non reliées électriquement entre elles et couvrant partiellement la zone active (12A).

5. Dispositif selon l'une quelconque des revendications précédentes dans lequel les première et deuxième grilles latérales (G1, G2) présentent chacune un profil en forme de L, dans un plan (zy) parallèle à la direction z.

6. Dispositif selon la revendication précédente dans lequel le profil en forme de L de chacune des première et deuxième grilles latérales (G1, G2) est formé par une portion (14l) dite latérale de chacune des première et deuxième grilles latérales (G1, G2), s'étendant respectivement sur le premier et le deuxième bord (120) de la zone active (12A), et par une portion (14b) dite basale s'étendant au sein de la couche isolante (11), ladite portion (14b) basale s'étendant sous un plan passant par une face inférieure de la zone active (12A).

7. Dispositif selon l'une quelconque des revendications précédentes dans lequel la couche semi-conductrice (12) présente, en projection selon la direction z, une forme comprenant un premier et un deuxième contours (C1, C2) fermés qui partagent une section commune (C0), et dans lequel la zone active (12A) est située dans ladite section commune (C0), les première et deuxième grilles latérales (G1, G2) se trouvant respectivement à l'intérieur des premier et deuxième contours (C1, C2) fermés.

8. Dispositif selon la revendication précédente comprenant en outre des grilles secondaires (31, 32) au-dessus de la couche semi-conductrice (12) de part et d'autre de la section commune (C0), lesdites grilles secondaires (31, 32) étant configurées pour isoler électriquement des régions de source et drain (S, D) situées aux extrémités de la section commune (C0).

9. Dispositif selon l'une quelconque des revendications précédentes comprenant plusieurs grilles verticales (30, 30a, 30b), certaines grilles verticales recouvrant au moins partiellement la zone active (12A), et certaines autres grilles verticales ne couvrant pas la zone active (12A).

10. Dispositif selon l'une quelconque des revendications précédentes comprenant au moins un réservoir de charge de part et d'autre de la zone active (12A), à fleur de la grille verticale (30, 30a, 30b).

11. Procédé de réalisation d'un dispositif comprenant une structure de type métal-oxyde-semiconducteur formée à partir d'un empilement comprenant successivement, selon une direction z, une couche de support (10), une couche isolante (11) et une couche semi-conductrice (12), le dispositif comprenant en outre au moins une grille latérale (G1, G2) configurée pour contrôler électrostatiquement une distribution de porteurs de charge dans la couche semi-conductrice (12) perpendiculairement à la direction z, ledit procédé comprenant :
• une formation d'au moins une tranchée (20) traversant la couche semi-conductrice (12) et s'étendant jusque dans la couche isolante (11), ladite formation de tranchée (20) définissant ainsi une zone active (12A) de la couche semi-conductrice (12), et exposant des bords (120) de ladite zone active (12A),
• une formation d'une première barrière diélectrique sur chaque bord (120) exposé de la zone active (12A), ladite première barrière diélectrique formant en partie un flanc (200) de ladite au moins une tranchée (20),
• un dépôt d'une couche d'électrode (14) sur le flanc (200) de l'au moins une tranchée (20), et de préférence sur un fond (201) de l'au moins une tranchée (20), ladite couche d'électrode (14) présentant au moins une portion (14l) dite latérale sur le flanc (200) de l'au moins une tranchée (20), ladite portion latérale (14l) formant la grille latérale (G1, G2), et de préférence une portion (14b) dite basale sur le fond (201) de l'au moins une tranchée (20),
• un remplissage de l'au moins une tranchée (20) par un matériau diélectrique (15),
• une formation d'une deuxième barrière diélectrique (16) sur une face supérieure de la zone active (12A) et sur une extrémité (140) supérieure de la grille latérale (G1, G2) bordant la zone active (12A),
• une formation d'une grille verticale (30, 30a, 30b) sur la deuxième barrière diélectrique (16), au-dessus de la zone active (12A), configurée pour contrôler électrostatiquement la distribution de porteurs de charge dans la couche semi-conductrice (12) selon la direction z, de façon à obtenir la structure de type métal-oxyde-semiconducteur.

12. Procédé selon la revendication précédente comprenant en outre, avant formation de la deuxième barrière diélectrique (16), une gravure partielle de la portion latérale (14l) de couche d'électrode (14), configurée pour abaisser l'extrémité (140) supérieure de la grille latérale (G1, G2) sous un plan (P0) passant par la face supérieure de la zone active (12A).

13. Procédé selon l'une quelconque des revendications 11 à 12 comprenant, après remplissage de l'au moins une tranchée (20) et avant formation de la deuxième barrière diélectrique (16), une planarisation configurée pour que l'extrémité (140) supérieure de la grille latérale (G1, G2) soit plane parallèlement à un plan (P0) passant par la face supérieure de la zone active (12A).

14. Procédé selon l'une quelconque des revendications 11 à 13 dans lequel le dépôt de la couche d'électrode (14) est effectué également sur un fond (201) de l'au moins une tranchée (20), ladite couche d'électrode (14) présentant ainsi une portion basale (14b) sur le fond (201) de l'au moins une tranchée (20) en contact avec la portion latérale (14l) sur le flanc (200) de l'au moins une tranchée (20), ledit procédé comprenant en outre une formation d'un via de contact (40, 41, 42) au travers du matériau diélectrique (15) configurée pour contacter électriquement la portion basale (14b) de la couche d'électrode (14).

15. Procédé selon l'une quelconque des revendications 11 à 14 dans lequel la formation d'au moins une tranchée (20) est configurée pour former une première tranchée (21) d'un premier côté de la zone active (12A) et une deuxième tranchée (22) d'un deuxième côté de la zone active (12A), séparée de la première tranchée (21), et dans lequel le dépôt de la couche d'électrode (14) forme, respectivement dans les première et deuxième tranchées (21, 22), des première et deuxième grilles latérales (G1, G2) non reliées électriquement entre elles.

16. Procédé selon la revendication précédente dans lequel la couche semi-conductrice (12) présente une forme comprenant un premier et un deuxième contours (C1, C2) fermés qui partagent une section commune (C0), et dans lequel la zone active (12A) est située dans ladite section commune (C0), les première et deuxième grilles latérales (G1, G2) se trouvant respectivement à l'intérieur des premier et deuxième contours (C1, C2) fermés, ledit procédé comprenant en outre une étape de gravure configurée pour couper la couche semi-conductrice (12) de part et d'autre de la section commune (C0), de façon à isoler électriquement des régions de source et drain (S, D) situées aux extrémités de la section commune (C0).

17. Procédé selon la revendication 15 dans lequel la couche semi-conductrice (12) présente une forme comprenant un premier et un deuxième contours (C1, C2) fermés qui partagent une section commune (C0), et dans lequel la zone active (12A) est située dans ladite section commune (C0), les première et deuxième grilles latérales (G1, G2) se trouvant respectivement à l'intérieur des premier et deuxième contours (C1, C2) fermés, ledit procédé comprenant en outre, lors de la formation de la grille verticale (30, 30a, 30b) au-dessus de la zone active (12A), une formation de grilles secondaires (31, 32) au-dessus de la couche semi-conductrice (12) de part et d'autre de la section commune (C0), lesdites grilles secondaires (31, 32) étant configurées pour isoler électriquement des régions de source et drain (S, D) situées aux extrémités de la section commune (C0).
